Europäisches Patentamt

European Patent Office

Office européen des brevets

(19)

(11) Numéro de publication : **0 600 802 A1**

(12) # DEMANDE DE BREVET EUROPEEN

(21) Numéro de dépôt : **93402933.1**

(22) Date de dépôt : **03.12.93**

(51) Int. Cl.⁵ : **H03G 3/20, H03L 5/02**

(30) Priorité : **04.12.92 FR 9214639**

(43) Date de publication de la demande :
**08.06.94 Bulletin 94/23**

(84) Etats contractants désignés :
**DE GB IT**

(71) Demandeur : **THOMSON-CSF**
**173, Boulevard Haussmann**
**F-75008 Paris (FR)**

(72) Inventeur : **Bouchet, André**
**THOMSON-CSF,**
**SCPI,**
**B.P. 329**
**F-92402 Courbevoie Cédex (FR)**

(74) Mandataire : **Lincot, Georges et al**
**THOMSON-CSF,**
**SCPI,**
**B.P. 329,**
**50, rue Jean-Pierre Timbaud**
**F-92402 Courbevoie Cédex (FR)**

(54) **Générateur d'ondes radiofréquences à puissance de sortie variable et régulée.**

(57) Le générateur selon l'invention comporte un convertisseur numérique-analogique (11) recevant sur une première entrée une information numérique correspondant à une valeur d'atténuation déterminée de la puissance ($P_S$) du signal de sortie (S), et recevant sur une deuxième entrée un courant de référence ($I_{réf}$) variable qui est fonction de la valeur d'atténuation (N) sélectionnée sur le CNA, et dont la sortie est couplée à un amplificateur (12) dont la sortie est couplée sur l'entrée par une résistance ($R_3$) de contre-réaction de l'amplificateur (12), la sortie de l'amplificateur (12) étant en outre rebouclée sur l'entrée du convertisseur (11) par une boucle (13) comportant au moins une résistance ($R_2$) pour faire varier le courant de référence ($I_{réf}$) de manière quasi exponentielle en fonction des valeurs des résistances ($R_1$, $R_2$ et $R_3$) du dispositif de commande (10) et obtenir en sortie de l'amplificateur (12) une tension de consigne ($V_c$) dont la variation est quasiment identique à celle de la tension détectée ($V_d$) permettant une précision sur le réglage de l'atténuation désirée quasi constante sur toute la dynamique de la puissance ($P_S$) du signal de sortie (S).

Application à tout générateur d'ondes radiofréquences.

FIG.1

EP 0 600 802 A1

FIG.2

La présente invention concerne un générateur d'ondes radiofréquences à puissance de sortie variable et régulée utilisant une boucle de régulation pour réguler le signal de puissance de sortie autour d'une valeur de consigne fournie par l'intermédiaire d'un convertisseur numérique-analogique, désigné ci-après par CNA, et commander le niveau de puissance du signal de sortie du générateur.

Dans les générateurs de type connu, une boucle de régulation prélève une fraction du signal de sortie du générateur qui après détection par un dispositif de type détecteur à diodes, est comparé à une table de tensions de consignes correspondant chacune à une valeur d'atténuation prédéterminée du signal de sortie. La régulation autour de la valeur de consigne prédéterminée est effectuée par comparaison du signal détecté par le dispositif de détection avec le signal de consigne avant la commande de l'atténuation. La fraction du signal de sortie détectée varie de façon exponentielle en fonction de la dynamique de la puissance du signal de sortie du générateur tandis que la tension analogique de sortie du CNA varie linéairement en fonction d'un nombre de pas dont le nombre maximal est déterminé pour couvrir toute la dynamique de la puissance du signal de sortie. Ceci entraîne une variation importante sur la précision du réglage de l'atténuation notamment pour les faibles niveaux de puissance du signal de sortie. Compte tenu de la variation exponentielle du signal détecté proportionnel à la puissance du signal de sortie, la précision sur le réglage de l'atténuation est moins bonne pour les faibles valeurs de puissance correspondant au début de la dynamique de puissance que pour les valeurs de puissance correspondant à la fin de la dynamique.

Afin de résoudre cet inconvénient, une première solution connue consiste à obtenir une tension de consigne qui varie de la même façon que la tension détectée à comparer. Pour cela un amplificateur anti-logarithmique est placé par exemple en sortie du CNA. Une deuxième solution consiste par exemple à placer un amplificateur logarithmique après le dispositif de détection de la boucle de régulation.

Les deux solutions précédentes ont pour principal inconvénient de nécessiter une mise en oeuvre complexe des amplificateurs logarithmique ou anti-logarithmique surtout très consommatrice en temps de mise au point.

L'invention a pour but de pallier l'inconvénient précité.

A cet effet l'invention a pour objet un générateur d'ondes radiofréquence comportant un circuit principal comportant au moins un dispositif délivrant un signal d'excitation, un atténuateur piloté par une tension de commande, un dispositif de traitement du signal d'excitation et comportant une boucle de régulation comportant un détecteur délivrant une tension de détection dont la variation est de forme exponentielle proportionnelle à la puissance du signal de sortie du générateur et un comparateur comparant la tension détectée à une tension de consigne délivrée par un dispositif de commande de l'atténuateur, caractérisé en ce que le dispositif de commande, organisé autour d'un circuit de masse servant de potentiel de référence, comporte un convertisseur numérique-analogique recevant sur une première entrée des informations numériques correspondant chacune à une valeur d'atténuation déterminée de la puissance du signal de sortie et recevant sur une deuxième entrée un courant de référence variable qui est fonction de la valeur d'atténuation sélectionnée sur le convertisseur et déterminé pour couvrir toute la dynamique de la puissance du signal de sortie, et dont la sortie est couplée à l'entrée d'un amplificateur, une résistance de contre-réaction de l'amplificateur étant couplée entre l'entrée et la sortie de l'amplificateur qui est en outre rebouclée sur l'entrée du convertisseur par une boucle comportant au moins une résistance, les valeurs des résistances du dispositif de commande étant déterminées en outre pour faire varier le courant de référence de manière quasi exponentielle et obtenir en sortie de l'amplificateur la tension de consigne dont la variation est quasiment identique à celle de la tension détectée avec une précision du réglage du niveau de puissance du signal de sortie, quasi constante sur toute la dynamique de la puissance du signal de sortie.

Le dispositif selon l'invention a pour principal avantage qu'il permet d'améliorer la précision de réglage de l'atténuation du niveau de puissance du signal de sortie pour les faibles niveaux de puissance en faisant varier d'une manière quasi exponentielle le courant de référence définissant le pas du CNA avec une mise en oeuvre simplifiée.

D'autres caractéristiques et avantages de l'invention apparaîtront ci-après à l'aide de la description faite en regard des dessins annexés qui représentent:
- la figure 1, un schéma synoptique simplifié d'un mode de réalisation d'un générateur selon l'invention,
- la figure 2, un schéma électrique d'un mode de réalisation d'un dispositif de commande d'atténuation, et
- les figures 3a et 3b, des caractéristiques correspondant respectivement à la variation de la tension de consigne en fonction du nombre de pas, et à la variation de la tension détectée en fonction de la dynamique de puissance du signal de sortie.

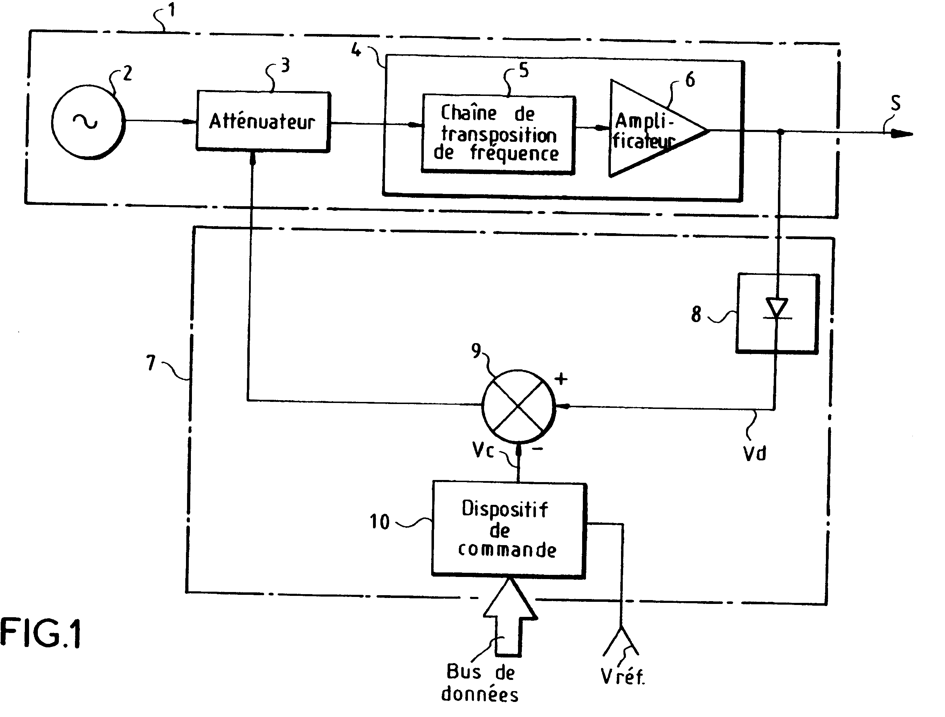

La figure 1, illustre un schéma synoptique simplifié d'un générateur d'ondes radiofréquences comportant un circuit principal 1, représenté à l'intérieur d'une ligne fermée discontinue, et comportant, de l'entrée vers la sortie, un dispositif 2 d'excitation délivrant par exemple un signal de fréquence intermédiaire, FI, de 1,4 MHz modulé par un signal basse fréquence, dont la sortie est couplée à une première entrée d'un atténuateur commandé 3. La sortie de l'atténuateur 3 est couplée à un dispositif de traitement 4 représenté à l'intérieur d'une ligne fermée continue comportant, par exemple une chaîne de transposition de fréquence 5 couplée à un amplificateur de sortie 6 délivrant sur sa sortie un signal radiofréquence S. Une boucle 7 représentée à l'intérieur d'une ligne fermée discontinue prélève une fraction de la puissance $P_S$ du signal S qui est injectée à l'entrée d'un dispositif de détection 8, par exemple à diodes, dont la sortie délivrant une tension $V_d$ est couplée à une première entrée positive d'opérande d'un comparateur 9. Une deuxième entrée d'opérande négative du comparateur 9 reçoit un signal analogique de consigne, par exemple une tension $V_c$, issue d'un dispositif de commande 10 de l'atténuateur 3 recevant sur une première entrée une tension de référence $V_{réf}$ et sur une deuxième entrée un bus de données numériques correspondant chacune à une valeur d'atténuation prédéterminée. Le signal issu de la comparaison est injecté sur une deuxième entrée de l'atténuateur 3.

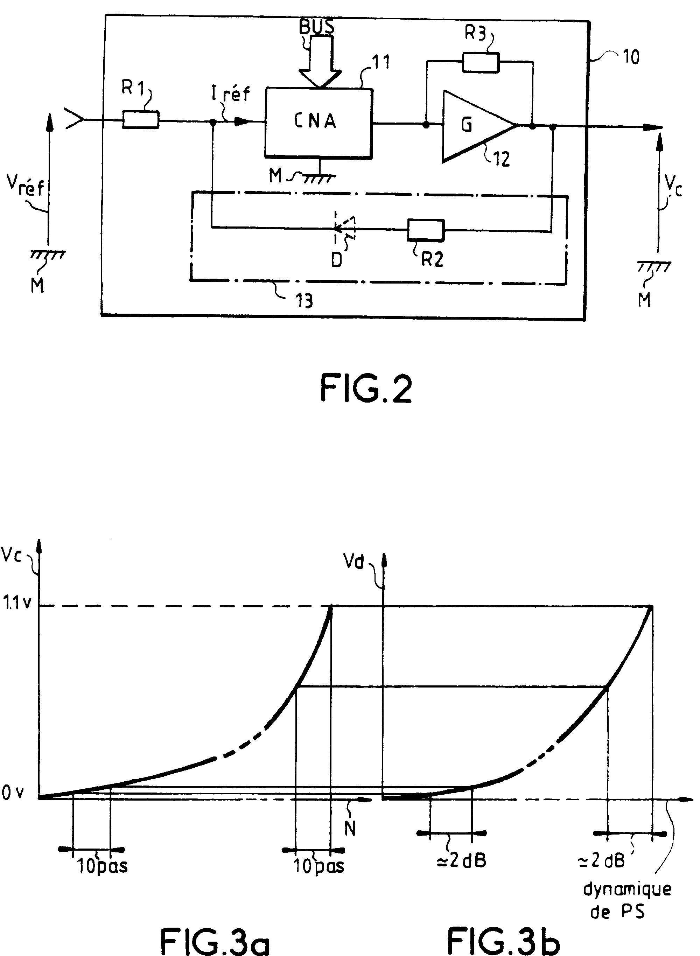

Un schéma électrique d'un mode de réalisation du dispositif de commande 10 est illustré par la figure 2. Le dispositif de commande 10, représenté à l'intérieur d'une ligne continue, est organisé autour d'un potentiel de référence, par exemple, un potentiel de masse M. Il comporte de l'entrée vers la sortie, une première résistance $R_1$ recevant sur une de ses bornes la tension de référence $V_{réf}$, l'autre borne étant couplée à une première entrée d'un CNA 11 recevant sur une deuxième entrée un bus de données numériques. La sortie du CNA 11 est couplée à l'entrée d'un amplificateur 12 à gain fixe, par exemple égal à un, servant d'étage d'adaptation en sortie du dispositif de commande 10. Une résistance $R_3$ déterminant le gain de l'amplificateur 12 est couplée entre la sortie et l'entrée de l'amplificateur 12. La sortie de l'amplificateur 12 est en outre rebouclée sur l'entrée du CNA 11 qui correspond également à une des bornes de la première résistance $R_1$, par une boucle 13, représentée à l'intérieur d'une ligne discontinue. La boucle 13 comporte une résistance $R_2$ et une diode D facultative, représentée en traits interrompus, pouvant être couplée entre la résistance $R_2$ et la première entrée du CNA.

Les trois résistances $R_1$, $R_2$ et $R_3$ du dispositif de commande 10 permettent la détermination du courant de référence $I_{réf}$ rentrant sur la première entrée du CNA 11 et conditionnent l'allure quasi exponentielle de la tension de consigne $V_c$ en sortie de l'amplificateur 12.

Le signal de sortie, ou tension de consigne, $V_c$ délivré par le dispositif de commande 10 est ensuite injecté sur l'entrée d'opérande négative du comparateur 9.

Dans ce mode de réalisation, l'expression de la tension de consigne $V_c$, déterminée pour couvrir toute la dynamique de la puissance $P_S$ du signal de sortie S du générateur, est donnée par l'équation suivante :

$$(1) \qquad V_c = I_{réf} R_3 N$$

où N correspond à la valeur d'atténuation désirée dont la valeur maximale est définie par la capacité du CNA. Cette capacité détermine également la précision du réglage de la puissance $P_S$ du signal de sortie S. Chaque information binaire amenée par le bus est convertie, par exemple à partir d'une table de valeurs prédéterminées, en une tension analogique de consigne $V_c$ à la sortie du CNA. Le courant $I_{réf}$ est la somme de deux courants définis par l'expression suivante :

$$(2) \qquad I_{réf} = \frac{V_{réf}}{R_1} + \frac{V_c}{R_2}$$

En reportant l'expression (2) dans l'expression (1) la tension $V_c$ s'exprime alors de la manière suivante :

$$(3) \qquad V_c = V_{réf} \frac{R_2}{R_1} \left( \frac{R_3 N}{R_2 - R_3 N} \right)$$

avec la condition aux limites suivante $R_3 < R_2$.

Une application numérique est donnée ci-après à titre d'exemple.

La dynamique de la puissance $P_S$ du signal de sortie S est de 30 dB. Le pas d'atténuation est choisi égal à 3 dB avec une précision sur chaque pas d'atténuation meilleure que 0,5 dB. Pour couvrir cette dynamique de 30 dB, un CNA codé sur huit bits est utilisé. Les valeurs d'atténuation N varient donc de :

$$\frac{1}{256} \leq N \leq \frac{255}{256}$$

Les valeurs des résistances $R_1$, $R_2$ et $R_3$ sont les suivantes : $R_1 = 100\ K\Omega$, $R_2 = 6,2\ K\Omega$ et $R_3 = 4,64\ K\Omega$. La tension de référence $V_{réf}$ est choisie égale à $V_{réf} = 6V$.

L'expression (3) compte tenu des valeurs ci-dessus permet de relever la caractéristique tension de consigne $V_c$ en fonction de l'atténuation N. Pour cet exemple, la valeur maximale de la tension de consigne pour N proche de 1 est égale à $V_c = 1,1V$. Cette application numérique est illustrée par les courbes des figures 3a et 3b. Sur la figure 3a l'axe des ordonnées correspond à la tension de consigne $V_c$ gradué de 0V à 1,1V et l'axe des abscisses correspond aux valeurs d'atténuation N. La courbe de la figure 3a est mise en concordance avec celle de la figure 3b qui représente la variation de la tension détectée $V_d$ représentée par l'axe des ordonnées en fonction de la dynamique de la puissance $P_s$ du signal de sortie S représentée par l'axe des abscisses. Deux intervalles de dix pas consécutifs sont choisis respectivement en début et en fin de caractéristique $V_c$ fonction de N, ces intervalles sont reportés sur la caractéristique $V_d$ fonction de la dynamique de $P_S$, et la variation de dynamique obtenue est quasiment identique en début et en fin de dynamique, et de l'ordre de 2 dB dans cet exemple, soit une précision de l'ordre de 0,2 dB par pas. L'échelle des axes des abscisses des deux figures n'étant pas respectée, les axes des abscisses et les courbes sont partiellement interrompus.

La diode D n'est pas indispensable au fonctionnement du générateur selon l'invention néanmoins elle aide à la détermination des valeurs des résistances $R_1$ et $R_3$ du dispositif de commande 10 dans la zone de fonctionnement ou la diode D est bloquée, c'est-à-dire pour les valeurs de la tension de consigne $V_c$ inférieures à la tension de seuil de détection de la diode.D Tant que la tension de consigne $V_c$ n'a pas atteint la tension de seuil de la diode D, la boucle 13 du dispositif de commande 10 n'est pas activée. La caractéristique $V_c$ en fonction des valeurs d'atténuation N se réduit alors à une droite dont la pente est fonction de la valeur des résistances $R_1$ et $R_3$ pour obtenir une précision en dB suffisante par pas d'atténuation dans le bas de la caractéristique $V_c$ fonction de N. Dans la zone de conduction de la diode D, la boucle 13 est activée et l'allure de la caractéristique devient alors quasi exponentielle, telle qu'illustrée par la figure 3a, avec une pente de départ identique à la pente donnée par le dispositif de commande 10, la boucle 13 étant désactivée. La caractéristique suit alors au plus près la variation de la tension détectée $V_d$ fonction de la dynamique de la puissance $P_S$ du signal de sortie S.

## Revendications

1. Générateur d'ondes radiofréquence comportant un circuit principal (1) comportant au moins un dispositif (2) délivrant un signal d'excitation, un atténuateur (3) piloté par une tension de commande, un dispositif de traitement (4) du signal d'excitation et comportant une boucle de régulation (7) comportant un détecteur (8) délivrant une tension de détection ($V_d$) dont la variation est de forme exponentielle proportionnelle à la puissance ($P_S$) du signal de sortie (S) du générateur et un comparateur (9) comparant la tension détectée ($V_d$) à une tension de consigne ($V_c$) délivrée par un dispositif de commande (10) de l'atténuateur (3), caractérisé en ce que le dispositif de commande (10), organisé autour d'un circuit de masse servant de potentiel de référence (M), comporte un convertisseur numérique-analogique (11) recevant sur une première entrée des informations numériques correspondant chacune à une valeur d'atténuation déterminée de la puissance ($P_S$) du signal de sortie (S) et recevant sur une deuxième entrée un courant de référence ($I_{réf}$) variable qui est fonction de la valeur d'atténuation (N) sélectionnée sur le convertisseur (11) et déterminé pour couvrir toute la dynamique de la puissance ($P_S$) du signal de sortie (S), et dont la sortie est couplée à l'entrée d'un amplificateur (12), une résistance ($R_3$) de contre-réaction de l'amplificateur (12) étant couplée entre l'entrée et la sortie de l'amplificateur (12) qui est en outre rebouclée sur l'entrée du convertisseur (11) par une boucle (13) comportant au moins une résistance ($R_2$), les valeurs des résistances ($R_1$, $R_2$ et $R_3$) du dispositif de commande (10) étant déterminées en outre pour faire varier le courant de référence ($I_{réf}$) de manière quasi exponentielle et obtenir en sortie de l'amplificateur (12) la tension de consigne ($V_c$) dont la variation est quasiment identique à celle de la tension détectée ($V_d$) avec une précision du réglage du niveau de puissance ($P_S$) du signal de sortie (S), quasi constante sur toute la dynamique de la puissance ($P_S$) du signal de sortie( S).

2. Générateur selon la revendication 1, caractérisé en ce que la boucle (13) du dispositif de commande (10) de l'atténuation du signal d'excitation comporte en outre au moins une diode de détection (D) dont l'anode est couplée à la résistance ($R_2$) de la boucle (13) et la cathode à l'entrée du convertisseur (11) pour déterminer la pente du début de la courbe de variation de la tension de consigne ($V_c$) fonction de la valeur d'atténuation (N) correspondant aux faibles niveaux de puissance ($P_S$) du signal de sortie (S) du générateur, en fonction des valeurs des résistances ($R_1$ et $R_3$) du circuit principal (1) du générateur quand la diode (D) est bloquée.

FIG.1

EP 0 600 802 A1

FIG.2

FIG.3a          FIG.3b

EP 0 600 802 A1

**Office européen**
**des brevets**

# RAPPORT DE RECHERCHE EUROPEENNE

Numero de la demande

EP 93 40 2933

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | EP-A-0 414 352 (ORBITEL MOBILE COMMUNICATIONS LIMITED)<br>* colonne 2, ligne 45 - colonne 3, ligne 33; figure 2 *<br>* colonne 4, ligne 7 - colonne 5, ligne 43 * | 1 | H03G3/20<br>H03L5/02 |
| | --- | | |
| Y | DE-A-32 36 148 (SIEMENS AG)<br>* le document en entier * | 1 | |
| A | | 2 | |
| | --- | | |
| A | DE-A-34 33 901 (SIEMENS AG)<br>* le document en entier * | 1-2 | |
| | --- | | |
| A | IEEE JOURNAL OF SOLID-STATE CIRCUITS vol. 23, no. 3 , Juin 1988 , NEW YORK US pages 767 - 773<br>R. F. WOLFFENBUTTEL 'digitally programmable accurate current sources for logarithmic control of the amplification or attenuation in a gain cell.'<br>* figures 1-3 * | 1-2 | **DOMAINES TECHNIQUES RECHERCHES (Int.Cl.5)**<br><br>H03G<br>H03L |
| | ----- | | |

Le présent rapport a été établi pour toutes les revendications

| Lieu de la recherche | Date d'achèvement de la recherche | Examinateur |
|---|---|---|
| LA HAYE | 3 Février 1994 | Deconinck, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................................

& : membre de la même famille, document correspondant

EPO FORM 1503 03.82 (P04C02)

8